Europäisches Patentamt

European Patent Office

Office européen des brevets

(19)

(11) Publication number: **0 068 098**
**B1**

(12) **EUROPEAN PATENT SPECIFICATION**

(45) Date of publication of patent specification: **01.04.87**

(51) Int. Cl.⁴: **H 01 L 21/312, G 03 F 7/02**

(21) Application number: **82103552.4**

(22) Date of filing: **27.04.82**

(54) Process for fabricating a device involving use of a photoresist.

(30) Priority: **30.06.81 US 280150**

(43) Date of publication of application:
**05.01.83 Bulletin 83/01**

(45) Publication of the grant of the patent:
**01.04.87 Bulletin 87/14**

(84) Designated Contracting States:
**DE FR GB IT**

(56) References cited:
**DE-A-2 001 339**
**DE-A-2 455 357**
**US-A-3 549 368**

**Photoresist: De Fores McGraw Hill Book Company**

(73) Proprietor: **International Business Machines Corporation**
**Old Orchard Road**
**Armonk, N.Y. 10504 (US)**

(72) Inventor: **Marinace, John Carter**
**2096 Van Cortlandt Circle**
**Yorktown Heights New York 10598 (US)**
Inventor: **McGibbon, Ralph Charles**
**2835 Old Yorktown Road**
**Yorktown Heights New York 10598 (US)**

(74) Representative: **Hobbs, Francis John**
**IBM United Kingdom Limited Intellectual**
**Property Department Hursley Park**
**Winchester Hampshire SO21 2JN (GB)**

## Description

This invention relates to a process for fabricating a device and is especially concerned with improving the adhesion of a photoresist to a body in the course of fabricating the device.

In the fabrication of various articles, it is often necessary to protect preselected areas of the surface while other areas of that same surface are exposed to particular treatments and/or process procedures. For instance, in the fabrication of semiconductor devices wherein, for example, an oxide layer is formed on a semiconductor substrate, it is often necessary to remove selected portions of the oxide layer so as to allow diffusion of a suitable impurity through the oxide layer openings into the underlying semiconductor substrate. Exemplary of such procedures is the fabrication of semiconductor devices, such as single crystal field effect transistors.

The above type of devices are formed by vapor diffusing a suitable impurity into a wafer of a single silicon crystal to form suitably doped regions therein. However, in order to provide distinct P or N regions, which are necessary for the proper operation of the device, diffusion should occur through only a limited portion of the substrate. Usually, this is accomplished by masking the substrate with a diffusion resistant material, such as silicon dioxide, which is formed into a protective mask to prevent diffusion through preselected areas of the substrate.

The silicon dioxide mask is typically provided by forming a uniform oxide layer over the wafer substrate and thereafter creating a series of openings through the oxide layer to allow the passage of the impurity directly into the underlying surface within a limited area. These openings are readily created by coating the silicon dioxide with a material known as a photoresist. Photoresists can be negative photoresist or positive photoresist materials. A negative photoresist material is one which is capable of polymerizing and becoming insoluble on exposure to light. Accordingly, when employing a negative photoresist material, the photoresist layer is selectively exposed to light, causing polymerization to occur above those regions of the silicon dioxide which are intended to be protected during a subsequent operation. The unexposed portions of the photoresist are removed by a solvent which is inert to the polymerized portion of the resist and a suitable etchant for the silicon dioxide, such as hydrogen fluoride, is applied to remove the unprotected oxide regions.

The positive resist material is one thatupon exposure to light is capable of being rendered soluble in a solvent in which the unexposed resist is not soluble.

Accordingly, when employing a positive photoresist material, selective exposure to light causes a reaction to occur above those regions of the silicon oxide which are not intended to be protected during the subsequent processing. The exposed portions of the photoresist are removed by a solvent which is not capable of dissolving the unexposed portion of the resist. Then a suitable etchant for the silicon dioxide, such as hydrogen fluoride, is applied to remove the unprotected oxide regions.

In developing the photoresist pattern, the photoresist intended to remain often lifts at the edges, especially if the humidity is high; thereby, exposing additional areas of the silicon surface to the impurity diffusion and creating deleteriously indistinct P- or N-type regions junctions. The resulting semiconductor devices are, therefore, characterized by significantly decreased output relative to that which theoretically could be provided. Moreover, since in field effect transistors at least two openings must be created through the oxide surface corresponding to the source and drain region of the device, there are at least four edges whose lack of resolution will influence the width of the source and drain and, more importantly, the width of the gate lying between the source and drain. Also, since the impurity tends to spread after entering the silicon body and since two separate diffusion regions are being generated simultaneously, the probability of shorting within the device, especially if narrow gate widths are desired, becomes increasingly more probable as the lack of resolution increases.

Recognizing this problem, the art with respect to negative photoresist proposed heating the photoresist prior to etching, such as by post-baking, in an attempt to provide a more adherent bond between the silicon dioxide surface and the resist. Post-baking has not been entirely satisfactory, since among other things, its effectiveness is largely dependent on the particular oxide surface being treated and on the surface conditions of that oxide surface, such as whether it contains impurities or moisture. Also, the normal variations in the oxide thickness result in certain layers being exposed to the etching solution longer than others, thereby accentuating the degree of resist curling and lifting, and requiring a greater degree of post-baking in some regions than in others for the same substrate. Also, after the treating of the selected portions of the surface, the post-baked photoresist is often more difficult to remove than one which has not been post-baked. Accordingly, post-baking has not been a completely satisfactory procedure.

It has also been suggested to precoat the silicon dioxide layer with an adhesive composition which would bond the photoresist to the silicon dioxide substrate. Various adhesive compositions have been proposed but have not been entirely satisfactory. Many, although having suitable bonding abilities, are considered generally toxic and highly reactive with air and moisture and often also require some degree of post-baking.

One of the more conventional ways to alleviate this problem now is to provide a liquid hexaalkyldisilazane adhesive on a substrate just before the photoresist is applied thereto of US—A—3 549 368. Although hexaalkyldisilazanes significantly improve the adhesion, they are somewhat limited when the strips to be defined become very narrow and/or the humidity in the processing becomes relatively high, such as above about 40%.

The invention provides a process for fabricating a semiconductor device including the successive steps of applying a film of adhesion-promoting material to a surface of a substrate, coating the surface with a layer of photoresist and exposing selected areas of the photoresist to light and is characterised in that (a) it involves defining narrow lines about 2 microns or less in width and is performed at a high relative humidity of about 40% or more, (b) the substrate is of gallium arsenide, silicon, glass, silicon dioxide or silicon nitride, (c) the film of adhesion-promoting material is about 1 to 300 mn thick, (d) the adhesion-promoting material consists of one or more of titanium, zirconium, hafnium, titanium oxide, zirconium oxide and hafnium oxide, and (e) the photoresist is a positive photoresist based on a formaldehyde novolak resin and a diazoketone.

It has been found that by application of the present invention, poor adhesion, even when employing narrow strips such as about 2 microns or less and even in the presence of relatively high humidity, such as about 40% and above, can be overcome. It has been found that the photoresist material can be firmly and adherently bound to a substrate so preventing "curling" or lifting of the photoresist from the substrate and, consequently, preventing undercutting of the substrate during etching. Accordingly, the present invention is especially useful for fabricating semiconductor devices having a high output capability and having a high degree of gate and source resolution.

How the invention can be carried out will now be described by way of example, with reference to the accompanying drawings, in which:—

Figs. 1.1—1.9 illustrate a sequence of steps for fabricating a MOS-type field effect transistor; and

Fig. 2 is a schematic diagram of an apparatus suitable for applying a film of titanium dioxide to a surface.

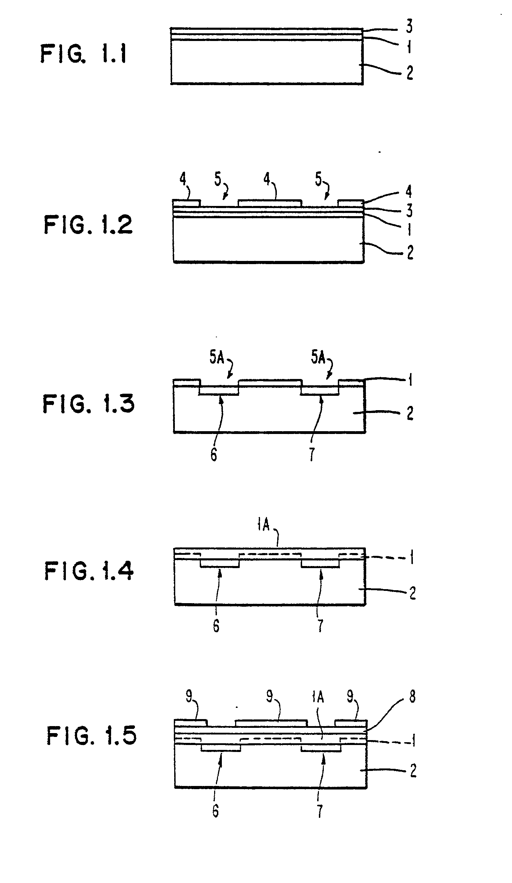

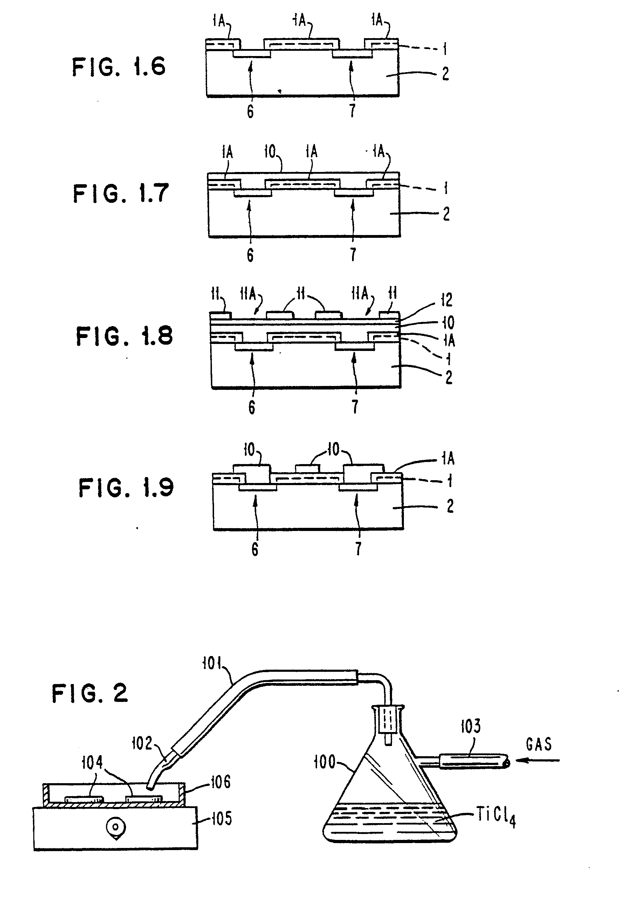

To facilitate understanding the present invention, reference can be made to fabrication of a semiconductor device in which a silicon dioxide layer 1 (Fig. 1.1) is provided on a single crystal silicon wafer substrate 2. The silicon dioxide layer can be formed by any of the well-known techniques, such as evaporation of silicon dioxide onto the silicon substrate, thermal oxidation of the silicon surface with oxygen, water moisture, air or other oxidizing medium or thermal decomposition of siloxane or the like.

The thickness of the oxide may vary from a few hundred angstroms to many hundreds of thousands of angstroms depending upon the oxidation step or particular purpose for which the oxide is formed.

In addition, although reference is being made to a silicon dioxide layer, the present invention is applicable to any substrate for which there is a problem of adhesion of photoresist. Of course, there are a few substrates in which such a problem does not occur, such as with sapphire substrates. Specific examples of some suitable semiconductor substrates include gallium arsenide, silicon, and polycrystalline silicon. In addition, exemplary of some silicon-containing substrates are glass, silicon dioxide, and silicon nitride.

One suitable method for forming a silicon dioxide surface is by oxidation of a silicon substrate at a temperature of about 800—1100°C in an oxygen or steam atmosphere for a period ranging from a few minutes to about 4 hours. After the oxide layer is formed, a thin coating 3 of an adhesion promoter is applied thereto.

The coating 3 can be titanium, zirconium, hafnium, oxides of these metals such as titanium dioxide, and zirconium dioxide, hafnium dioxide or mixture of any of the above. The preferred coating is titanium dioxide.

The adhesive can be applied by any one of several common coating techniques. Such techniques include sputtering and electron beam evaporation. Titanium dioxide films can be conveniently applied by hydrolysis of $TiCl_4$; the hydrolysis-pyrolysis of titanium tetraisopropoxide $Ti(OC_3H_7)_4$ such as discussed by Hardee et al, *Journal of American Electrochemical Society*, Vol, 122, No. 6, page 739, and by sputtering. The preferred method of applying titanium dioxide is by the hydrolysis of $TiCl_4$.

A typical such process includes adding $TiCl_4$ into flask 100 (see Fig. 2) at room temperature and conveying the $TiCl_4$, through a length of Viton tubing 101 and then a glass nozzle 102. Viton is a copolymer of hexafluoropropylene and 1,1-difluoroethylene. A gas, such as $N_2$, $O_2$, or He is passed via conduit 103 into the flask and over the liquid $TiCl_4$ in the flask at about room temperature and conveys the $TiCl_4$ through the tubing 101 and glass nozzle 102. The gas stream exits the nozzle at about 5 cm distance from the wafers or substrates 104 in holder 106. The wafers are at a temperature of about room temperature to about 300°C, and preferably at about room temperature to about 100°C. When desired, the wafers are heated by use of a hot plate 105. The thickness of the $TiO_2$ layer is about 10 to about 3000 Å, and preferably about 25 Å. The time employed for coating, for instance, a 3 × 3 cm wafer is about 2 to about 3 seconds at a temperature of about 100°C and about 5 seconds when the substrate is at room temperature.

As discussed hereinabove, the film can be deposited, for instance, by the hydrolysis-pyrolysis of titanium tetraisopropoxide by employing the same type of equipment as discussed hereinabove for the process employing $TiCl_4$, except that the titanium tetraisopropoxide is placed in flask 100 and is heated to a temperature of about 65 to about 85°C. In addition, the temperature of the wafer substrate is generally about 350°C.

A sputtering technique can be carried out, for instance, using a titanium target and a gas of about 100% oxygen at 20 microns with a −2000 volt cathode with the substrates at −50 volts and about 33 mm distance apart. The temperature of the substrate wafer is about 150°C, providing about a 45 Å per minute growth rate.

After the adhesion-promoting layer is deposited, the photoresist material 4 (see Fig. 1.2) is then applied over the layer 3. Photoresist materials found to be especially suitable include compositions based on phenol formaldehyde novalak polymers. A particular example of such is Shipley 1350 which is an m-cresol formaldehyde novalak polymer composition. Such is a positive resist composition and includes therein a diazoketone, such as 2-diazo-1-naphthol-5-sulphonic acid ester. In such a composition, the ortho-diazoketone is converted to a carboxylic acid during the photochemical reaction. This, in turn, converts a neutral-organic soluble molecule (the phenolic polymer) to one that is readily soluble in weakly alkali aqueous developer solvents. The composition usually contains about 15% or so by weight of the diazoketone compound. In addition, in other systems, the diazoketone is actually attached directly to the polymer molecules. In such a system, as a result of the association between the polymer and the diketone, the solubility of the mixture in the alkaline developer is inhibited. The hydrophobic nature of the polymer further inhibits attack by the developer. On exposure to light, the diketone liberates a molecule of nitrogen and undergoes a molecular rearrangement to the alkali-soluble acid. Formation of the polar carboxyl groups in the exposed areas also renders the film less hydrophobic and, thus, more easily attacked by the aqueous alkaline developer solution. A discussion of photoresist materials can be found, for instance, in *Journal of the Electrochemical Society*, Vol. 125, No. 3, March 1980 — Deckert et al, "Microlithography — Key to Solid-State Fabrication", pp. 45C—56C.

The photoresist is generally applied in a thickness of about 1 to about 2 microns.

Of course, the thickness of the photoresist to be applied depends upon the particular photoresist used and upon the particular technique and purpose for applying the photoresist. The photoresist layer is subjected to a suitable light pattern so as to cause selective reaction which provides a source-drain pattern 5 of Fig. 1.2 on the silicon dioxide layer. The exposed regions of the photoresist are then removed with a suitable solvent, such as an aqueous alkaline solution. The exposed portions of the adhesion-promoting layer can then be removed by a suitable etchant. For instance, in the case of titanium dioxide, buffered HF can be employed. Also HCl, either concentrated or as a 50% diluted solution in water, will slowly etch titanium dioxide. However, it has been found that the HCl will also remove underlying $SiO_2$ if the titanium dioxide was deposited by the sputtering process discussed hereinabove or by the use of the tetraisopropoxide.

On the other hand when deposited using the $TiCl_4$ process, as discussed hereinabove, with substrate temperatures of room temperature to about 100°C or higher, removal of underlying $SiO_2$ on the use of HCl does not occur. Etching in buffered HF provides the source openings 5A in the $SiO_2$ layer 1 of Fig. 1.3.

After stripping off the photoresist with a suitable solvent such as IRCL J100 from INDUST-RI-CHEM LABORATORY, an N-type diffusion can be carried out with phosphorus, arsenic, or antimony to form the source 6 and drain 7 regions with an undiffused region between them which will subsequently become the gate or conductor channel. Next, a second layer 1A of silicon dioxide of about 1000 to about 5000 Å thickness may be deposited over the surface, as illustrated in Fig. 1.4. For purposes of continuity, the two silicon dioxide layers 1 and 1A are differentiated from the other, although in actuality, they are continuous. A coating of titanium dioxide 8 is again applied over the silicon dioxide layer, such as using the $TiCl_4$ process discussed hereinabove. A photoresist layer 9, such as Shipley AZ 1350 is then formed over the adhesion-promoting layer, such as shown in Fig. 1.5. The silicon dioxide in the open portions of the pattern is etched as previously described with buffered HF, and the photoresist and titanium dioxide are then removed entirely, which results in the structure shown in Fig. 1.6.

A metallic-type interconnection material 10, such as aluminum, is evaporated over the entire surface resulting in the structure illustrated in Fig. 1.7. Metallic-type interconnection refers to lines or strips of metal such as aluminum as well as to nonmetallic materials, such as highly doped polysilicon or intermetallic silicides which, nevertheless, have electrical conductivities of the magnitude generally possessed by metals. Next, a layer of photoresist 11 is deposited and developed as shown in Fig. 1.8. In addition, if desired, an adhesion-promoting layer as employed hereinabove can also be employed between the photoresist material and the metallic-type interconnection material. The photoresist and, if present, the underlying adhesion promoter is developed as illustrated in Fig. 1.8. After developing the photoresist, the aluminum in the open portions of the photoresist pattern 11A is etched with a hydroxide solution resulting in the structure shown in Fig. 1.9.

While this invention has been described principally in terms of preparing semiconductor devices, it should be understood that its general applicability is to any process which requires adhering a photoresist material to an underlying substrate and particularly to a semiconductor substrate, metallic substrate, or silicon-containing substrate. For example, the techniques of this invention can be used for preparing printed circuit boards, flat film memory units, wherein a thin film is protected by an oxide surface, doped layer modules, gravure printing, wherein an oxide base is involved, preparation of photomasks in general for glass plate and many other uses.

The present invention provides for much improved adhesion of photoresist to a substrate.

One particular photoresist tested was Shipley AZ 1350 which was developed using Shipley AZ developer at about 44% relative humidity.

## Claims

1. A process for fabricating a semiconductor device including the successive steps of applying a film of adhesion-promoting material to a surface of a substrate, coating the surface with a layer of photoresist and exposing selected areas of the photoresist to light, the process being characterised in that (a) it involves defining narrow lines about 2 microns or less in width and is performed at a high relative humidity of about 40% or more, (b) the substrate is of gallium arsenide, silicon, glass, silicon dioxide or silicon nitride, (c) the film of adhesion-promoting material is about 1 to 300 mn thick, (d) the adhesion-promoting material consists of one or more of titanium, zirconium, hafnium, titanium oxide, zirconium oxide and hafnium oxide, and (e) the photoresist is a positive photoresist based on a formaldehyde novolak resin and a diazoketone.

2. A process as claimed in claim 1, in which the adhesion-promoting material is titanium oxide.

3. A process as claimed in claim 2, in which the film of titanium oxide is applied by hydrolysis of TiCl$_4$.

4. A process as claimed in claim in any preceding claim, in which the substrate is at a temperature of about room temperature to about 300°C during application of the adhesion-promoting material.

5. A process as claimed in claim 4, in which the substrate is at a temperature of about room temperature to about 100°C during application of the adhesion-promoting material.

6. A process as claimed in any preceding claim, in which the adhesion-promoting film is about 2.5 nm thick.

## Patentansprüche

1. Verfahren zur Herstellung einer Halbleitervorrichtung mit den aufeinanderfolgenden Schritten des Aufbringens eines Films aus haftförderndem Material auf eine Oberfläche eines Substrats, Beschichtens der Oberfläche mit einer Schicht aus Photoresist und Belichtens ausgewählter Bereiche des Photoresists, wobei das Verfahren dadurch gekennzeichnet ist, daß (a) es das Definieren von schmalen Linien mit einer Breite von ungefähr 2 Mikrometer oder weniger beinhaltet und bei einer hohen relativen Feuchtigkeit von ungefähr 40% oder mehr durchgeführt wird, (b) das Substrat aus Galliumarsenid, Silizium, Glas, Siliziumdioxid oder Siliziumnitrid ist, (c) der Film aus haftförderndem Material ungefähr 1 bis 300 nm dick ist, (d) das haftfördernde Material aus einem oder mehreren von Titan, Zirkon, Hafnium, Titanoxid, Zirkonoxid und Hafniumoxid besteht, und (e) der Photoresist ein positiver Photoresist, basierend auf einem Formaldehyd-Novolakharz und einem Diazoketon, ist.

2. Verfahren nach Anspruch 1, bei welchem das haftfördernde Material Titanoxid ist.

3. Verfahren nach Anspruch 2, bei welchem der Film aus Titanoxid durch Hydrolyse von TiCl$_4$ aufgebracht wird.

4. Verfahren nach irgendeinem vorstehenden Anspruch, bei welchem das Substrat während des Aufbringens des haftfördernden Materials auf einer Temperatur von ungefähr Raumtemperatur bis ungefähr 300°C ist.

5. Verfahren nach Anspruch 4, bei welchen das Substrat während des Aufbringens des haftfördernden Materials auf einer Temperatur von ungefähr Raumtemperatur bis ungefähr 100°C ist.

6. Verfahren nach irgendeinem vorstehenden Anspruch, bei welchem der haftfördernde Film ungefähr 2,5 nm dick ist.

## Revendications

1. Un procédé de fabrication d'un dispositif semiconducteur, comprenant les étapes successives consistant à déposer un film d'une matière de promotion d'adhérence sur une surface d'un substrat, à revêtir la surface d'une couche de substance photosensible et à exposer des zones sélectionnées de la substance photosensible à la lumière, le procédé étant caractérisé en ce que (a) il consiste à définir des lignes étroites d'une largeur d'environ 2 microns ou moins et il est mis en oeuvre avec une humidité relative élevée d'environ 40% ou plus, (b) le substrat est formé d'arséniure de gallium, de silicium, de verre, de dioxyde de silicium ou de nitrure de silicium, (c) le film de matière de promotion d'adhérence a une épaisseur d'environ 1 à 300 nm, (d) la matière de promotion d'adhérence se compose d'un ou plusieurs des constituants suivants: titane, zirconium, hafnium, oxyde de titane, oxyde de zirconium et oxyde d'hafnium, et (e) la substance photosensible est une substance photosensible positive contenant une résine de novolak et de formaldéhyde et une diazocétone.

2. Un procédé tel que revendiqué dans la revendication 1, dans lequel la matière de promotion d'adhérence est un oxyde de titane.

3. Un procédé tel que revendiqué dans la revendication 2, dans lequel le film d'oxyde de titane est déposé par hydrolyse de TiCl$_4$.

4. Un procédé tel que revendiqué dans l'une quelconque des revendications précédentes, dans lequel le substrat se trouve à une température comprise entre environ la température ambiante et environ 300°C pendant le dépôt de la matière de promotion d'adhérence.

5. Un procédé tel que revendiqué dans la revendication 4, dans lequel le substrat se trouve à une température comprise entre environ la température ambiante et environ 100°C pendant le dépôt de la matière de promotion d'adhérence.

6. Un procédé tel que revendiqué dans l'une quelconque des revendications précédentes, dans lequel le film de promotion d'adhérence a une épaisseur d'environ 2,5 nm.

FIG. 1.1

FIG. 1.2

FIG. 1.3

FIG. 1.4

FIG. 1.5

FIG. 1.6

FIG. 1.7

FIG. 1.8

FIG. 1.9

FIG. 2

GAS

$TiCl_4$